## Europäisches Patentamt

## European Patent Office

## Office européen des brevets

(19)

(11) Veröffentlichungsnummer: **0 055 375**
**B1**

(12) **EUROPÄISCHE PATENTSCHRIFT**

(45) Veröffentlichungstag der Patentschrift:
10.10.84

(51) Int. Cl.³: **H 03 K 3/295, H 03 K 5/02**

(21) Anmeldenummer: 81109160.2

(22) Anmeldetag: 29.10.81

(54) **Gegentakt-Treiberschaltung mit verringerter Störspannungserzeugung.**

(30) Priorität: 30.12.80 US 221687

(43) Veröffentlichungstag der Anmeldung:
07.07.82 Patentblatt 82/27

(45) Bekanntmachung des Hinweises auf die Patenterteilung:
10.10.84 Patentblatt 84/41

(84) Benannte Vertragsstaaten:
DE FR GB

(56) Entgegenhaltungen:
GB - A - 1 426 007
US - A - 3 867 649
US - A - 4 228 371

IBM TECHNICAL DISCLOSURE BULLETIN, Band 23, Nr. 10, März 1981, Seite 4501, New York, USA, G.M. BOUDON et al.: "Current mirror transition-rate limited driver"
IBM TECHNICAL DISCLOSURE BULLETIN, Band 21, Nr. 4, September 1978, Seiten 1454-1455, New York, USA, E.F. CULICAN et al.: "Schottky clamp for transistor breakdown"

(73) Patentinhaber: **International Business Machines Corporation, Old Orchard Road, Armonk, N.Y. 10504 (US)**

(72) Erfinder: **Gaudenzi, Gene Joseph, Oakridge Road, Purdys New York 10578 (US)**

(74) Vertreter: **Neuland, Johannes, Dipl.-Ing., Schönaicher Strasse 220, D-7030 Böblingen (DE)**

**Beschreibung**

Die Erfindung bezieht sich auf eine Gegentakt-Treiberschaltung mit verringerter Störspannungserzeugung durch den den niedrigen Ausgangspegel herbeiführender Ausgangstransistor.

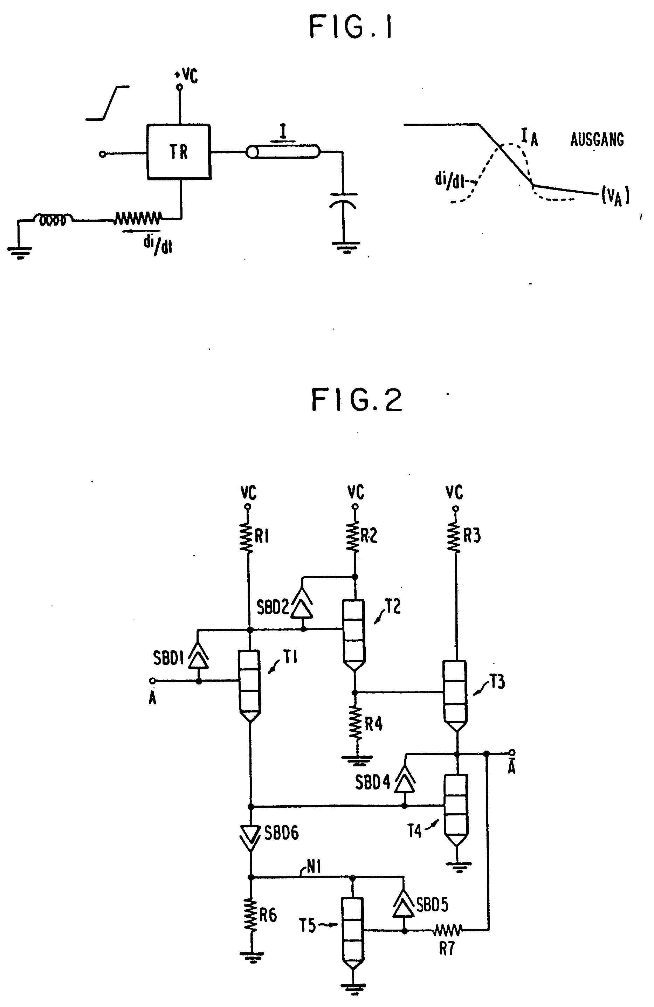

Systeme mit monolithisch hochintegrierten Halbleiterschaltungen benutzen Treiberschaltungen, die wegen der erforderlichen Gleichstromspeisung sehr schnell in den niedrigen Ausgangspegel schalten. In Fig. 1 ist die Übergangskurve für solch eine typische Treiberschaltung TR dargestellt mit einer gestrichelten Kurve für di/dt (Änderungsgeschwindigkeit des Ausgangsstromes). Die Kurven lassen den hohen Wert von di/dt und den Spitzenwert des Ausgangsstromes $I_A$ erkennen. Die in der streifenförmigen Induktivität L auf dem Halbleiterchip induzierte Spannung, kann dargestellt werden als $V_L = Ldi/dt$. Wenn eine bedeutende Anzahl von Treiberschaltungen (n) gleichzeitig schalten, kann dieser Wert der induzierten Spannung $V_L$, wenn er groß genug ist, andere Treiberschaltungen veranlassen, fälschlicherweise zu schalten. Außerdem ist die dem Halbleiterchip zugeführte Gesamtspannung bedeutsam, da sie den Störabstand auf dem Halbleiterchip begrenzt.

Bekannte Verfahren zur Begrenzung des durch die induzierte Spannung Ldi/dt auf dem Halbleiterchip hervorgerufenen Stromes verwenden Kondensatoren. Während solche Kondensatoren wirksam sind, um den induzierten Strom zu begrenzen, stellt die für solche Elemente benötigte Fläche des Halbleiterchips einen schweren Nachteil dar. Üblicherweise erfordern diese Kondensatoren eine Fläche von etwa 0,0062 mm². Daher besteht weiterhin die Forderung, die Gleichstromspeisung beizubehalten, während das Begrenzen der induzierten Spannung nur einen minimalen Betrag der Fläche des Halbleiterchips erfordern soll. Die Verwendung von Kondensatoren ist daher nicht wirkungsvoll, um diese verschiedenen Forderungen zu erfüllen.

Da das Vorhandensein der streifenförmigen Induktivität L als physikalische Eigenschaft vorgegeben ist sowie auch die Leiterzüge auf dem Halbleiterchip und das unerbittliche Wachsen der Anzahl der schaltenden Treiberschaltung mit der Zunahme der Dichte der logischen Schaltungen, besteht der einzige wirksame Weg zur Begrenzung der Gesamtspannung auf dem Halbleiterchip in dem Beeinflussen der zeitlichen Änderung di/dt des Stromes i. Jedoch wurde dieser Weg bisher nicht benutzt, sondern übliche, mit Kondensatoren arbeitende Verfahren vorgezogen. Wie schon erwähnt, kann solch eine Lösung zufriedenstellend sein, wenn die Fläche des Halbleiterchips keine Rolle spielt. Aber in den gegenwärtigen hochintegrierten Halbleiterschaltungen ist sie ein Hauptaspekt beim Entwurf.

Aus dem US Patent 3 867 649 ist eine Rückkopplungsschaltung mit einem Kondensator für ein Paar identischer Treiberschaltungen bekannt, die eine MOS-Feldeffekttransistorschaltung steuern. Dieses Patent zeigt die Verwendung einer Rückkopplungskapazität 52 nach dem Stand der Technik. Wenn im Betrieb das Ausgangspotential einer bestimmten Treiberschaltung abfällt, wird in der Rückkopplungskapazität 52 ein Strom entwickelt, der gleich ist CdV/dt. Dieser Stromfluß wird dazu, benutzt, Strom von der Basis des Transistors 48 abzuleiten und außerdem dazu, die Abfallzeit zu verlangsamen, wenn das Ausgangspotential sich zwischen den Pegeln ändert. Die Dioden 62 und 64 dienen mit den Spannungsteilerwiderständen 70 und 72 dazu, für eine gesteuerte, in einer Richtung erfolgende Rückkopplung zu sorgen. Daher werden Spitzen im Ausgangssignal begrenzt durch Ableiten des Stromes von der Basis des Transistors 48.

Verschieden von den Kapazitätsverfahren bietet die Betrachtung einer aktiven Rückkopplungsschaltung möglicherweise ein Verfahren zum Erfüllen der verschiedenen Kriterien.

Das US Patent 3 529 184 zeigt in Fig. 2 eine Modifikation eines Schmitt-Triggers, dem eine Eingangsspannung $e_n$ zugeführt wird und der einen Transistor 14 besitzt, dessen Emitter über den Emitterwiderstand 20 mit Masse verbunden ist. Ein normalerweise leitender Ausgangstransistor 22 in Emitterschaltung ist mit dem Transistor 14 verbunden. Der Emitterwiderstand 20 liefert gemeinsam mit den beiden Emittern der Transistoren eine positive Rückkopplung, die die bekannte Triggerwirkung der Schaltung zur Folge hat. Um den beim Leiten des Transistors 22 am Widerstand 20 auftretenden inneren Spannungsabfall zu überwinden, ist ein Rückkopplungstransistor 34 vorgesehen. Die Emitter des Ausgangstransistors 22 und des Rückkopplungstransistors 34 sind mit Masse verbunden, so daß, wenn der Transistor 22 voll leitend wird, die Spannung an dem Kollektor im wesentlichen auf das Massepotential abfällt. Daher ist bei dem Schmitt-Trigger nach Fig. 2 die Spannung der Basisleitung wesentlich näher bei Null als das bei üblichen Schaltungen der Fall ist.

Das US Patent 3 571 625 zeigt einen Impulsverstärker mit einem Rückkopplungstransistor 135, der nur während der Übergänge der Eingangsimpulse aktiv ist. Die Basis-Emitterdiode des Transistors 135 verhindert jede Rückkopplung durch die in Reihe geschalteten Widerstände während des Anliegens des Teils der Eingangsspannung, der einen konstanten Wert aufweist. Während der Übergänge des dem Transistor 115 zugeführten Signales sättigt die Basis-Emitterstrecke des Transistors, und der Transistor 125 ist im wesentlichen gesperrt. Eine positive Spannung am Kollektor 127 spannt die Basis-Emitterdiode des Transistors 135 in Vorwärtsrichtung vor und Strom fließt durch die Widerstände 131 und 133 und verstärkt das Leiten des Transistors 115. Daher tritt eine positive Rückkopplung nur während der Impulsflanken auf.

Die Schaltungen nach dem Stand der Technik verwenden entweder Rückkopplungskondensatoren, was jedoch den schweren Nachteil besitzt, daß große Anteile der Fläche des Halbleiterchips dafür benötigt werden oder sie verringern nicht die Signalverzögerungen beim Schalten mehrerer Treiberschaltungen.

Hier will die Erfindung Abhilfe schaffen. Die Erfindung, wie sie in den Ansprüchen gekennzeichnet ist, löst die Aufgabe eine Treiberschaltung anzugeben, die die zeitliche Stromänderung di/dt des Stromes i in steuerbare Weise so begrenzt, daß mehrere Treiberschaltungen gleichzeitig geschaltet werden können und die Signalverzögerungen möglichst klein gehalten werden.

Im folgenden wird die Erfindung in Verbindung mit der Zeichnung näher erläutert. In der Zeichnung zeigt

Fig. 1 schematisch eine Treiberschaltung und die beim Schalten entstehende Spannung;

Fig. 2 ein Detailschaltbild eines bevorzugten Ausführungsbeispieles der Erfindung.

Die in Fig. 2 dargestellte Treiberschaltung nach der Erfindung verwendet einen ersten Eingangstransistor T1 zusammen mit einem zweiten Transistor T2 und einem dritten Transistor T3, die in Kaskade geschaltet sind. Die Transistoren T1, T2 und T3 sind an eine Versorgungsspannung VC angeschlossen. Bei den Transistoren T1 und T2 sind Schottkydioden SBD1 und SBD2 zwischen Basis und Kollektor der Transistoren angeordnet, um deren Sättigung zu verhindern. Wenn der Transistor T1 sperrt, wird der Basis des Transistors T2 Basisstrom zugeführt, der den Transistor leitend macht. Der Transistor T2 macht den Transistor T3 in bekannter Weise leitend. Die Erfindung verwendet eine aktive Rückkopplung längs des Weges N1, um das in Fig. 1 dargestellte Abfallen der Ausgangsspannung oder die zeitliche Änderung di/dt des Stromes i auf einen gewünschten Wert zu begrenzen. Wenn die Rückkopplungsschleife nicht vorhanden wäre wenn der Transistor T1 leitend wird, würde der Transistor T4 unmittelbar leitend gemacht und die Ausgangsspannung Ā würde verringert. Zur Beeinflussung der Änderungsgeschwindigkeit, die auftritt, wenn die Eingangsspannung A zunimmt, dient bei der in Fig. 2 dargestellten Schaltung nach der Erfindung eine Schottkydiode SBD6, der Transistor T5 und der Widerstand R7.

Gemäß der Erfindung kann der Ausgangstransistor T4 nicht schnell leitend werden, da er dem Transistor T5 folgen muß. Der Transistor T5 wird durch den Rückkopplungswiderstand R7 zusammen mit der abfallenden Ausgangsspannung begrenzt. Wenn $VSBD_6 = VSBD_5$ dann:

$$VBE_{T4} = VBE_{T5} - VSBD5 + VSBD6$$
$$VBE_{T4} \approx VBE_{T5}$$

Daher kann der Wert der zeitlichen Stromänderung di/dt des Transistors T5 durch die Wahl der Widerstände R1 und R7 auf einen gewünschten Wert gebracht werden. Der Widerstand R6 ist erforderlich, um die Basis des Transistors T4 beim Schalten in den oberen Pegel zu entladen und ist an der Beeinflussung der Stromänderungsgeschwindigkeit di/dt aktiv nicht beteiligt.

Es sei zuerst der Fall betrachtet, daß der Ausgang Ā den hohen Pegel und der Eingang A den niedrigen aufweist. Der Transistor T5 ist dann leitend und versucht, den Rückkoppelungsweg N1 in der Nähe des Massepotentials festzuhalten. Wenn z. B. der Ausgang Ā einen Pegel von 3,5 V aufweist, weist der Rückkopplungspfad N1 etwa eine Spannung von 0,3 V auf. Der Transistor T4 ist gesperrt.

Wenn der Pegel am Eingang A hoch ist, wird der Transistor T1 leitend und der Pegel am Ausgang Ā verringert. Die Schottkydiode SBD6 gilt als Stromanzapfung, die den Basisstrom des Transistors T4 begrenzt. Die Stromanzapfung erlaubt es, beim Abfallen des Ausgangspegels die zeitliche Änderung des Stromes di/dt auf einen gewünschten Wert zu bringen. Wenn der Pegel am Ausgang Ā auf den niedrigen Wert abfällt, der etwa 600 mV beträgt, wird der Transistor T4 leitend und der Transistor T5 sperrt. Bei gesperrtem Transistor T5 ist kein Rückkopplungspfad mehr vorhanden. Dann existiert die maximale Gleichspannungssteuerung. Die Signalverzögerungen für den abfallenden Pegel werden verlangsamt, da zur Verringerung der zeitlichen Änderung di/dt des Stromes eine langsamere zeitliche Änderung $\Delta V / \Delta t$ erforderlich ist. Wenn beispielsweise die zeitliche Änderung $\Delta V / \Delta t$ der Ausgangsspannung durch Verwenden einer aktiven Rückkopplung von 2V/ns auf 1V/ns verringert wird, erhöht sich die Signalverzögerung der Treiberschaltung um 2ns bei abfallendem Pegel. Jedoch wird die zeitliche Änderung di/dt des Stromes um etwa 62% verringert, was es erlaubt, mehr Treiberschaltungen gleichzeitig zu schalten.

Wenn daher die Spannung am Ausgang Ā abfällt, bewegt sich der Transistor T5, der anfänglich leitend war und daher Basissteuerstrom von dem Ausgangstransistor T4 entfernte, auf den Sperrzustand zu. Dieser Vorgang begrenzt in Verbindung mit der Tatsache, daß die Basisemitterspannung $VBE_{T4}$ ungefähr gleich ist der Basisemitterspannung $VBE_{T5}$ des Transistors T5, die zeitliche Änderung di/dt des Stromes des Ausgangstransistors. Wenn der Ausgangspegel unter den Höchstwert für den niedrigen Pegel abfällt, ist der Transistor T5 vollständig gesperrt, so daß der gesamte Basisstrom dem Transistor T4 zugeführt wird. Der Widerstand R7 kann variiert werden, um für die Übergänge diskrete Werte zu erreichen.

Durch die Verwendung eines aktiven Rückkopplungsweges wird eine bedeutsame Verringerung der benötigten Fläche des Halbleiterchips erreicht. Die beim Stand der Technik verwendeten Kondensatoren erfordern Flächen auf dem Halbleiterchip im Bereich von 0.0062 mm². Dagegen werden nach der Erfindung nur etwa 0,001 mm² benötigt, was einem Sechstel der vorher angegebenen Fläche entspricht.

Beim Aufbau der Schaltung nach Fig. 2 sollten die Schottkydioden SBD5 und SBD6 von gleicher Ausführung sein. Dies gewährleistet die ungefähre Gleichheit der Basisemitterspannungen der Transistoren T4 und T5 (während des Schaltens) und eliminiert Fehler aufgrund der Schwankungen bei der Herstellung. Um diesen Aspekt der Erfindung zu demonstrieren wurde festgestellt, daß ein Rückkopplungskondensator mit einer Kapazität von 1,25 pF die zeitliche Änderung $\Delta V/\Delta t$ der Spannung V auf akzeptable Werte begrenzt. Unter der Annahme, daß eine Kapazität von 0,132 pF/0,000625 mm² erzeugt werden kann, sind für eine Gesamtkapazität von 1,25 pF 0,0064 mm² erforderlich. Die Realisierung der Schottkydiode SBD6, des Transistors T5 und des Widerstandes R7 erfordern etwa eine Fläche von 0,001 mm², was in einer sechsfachen Ersparnis an Chipfläche resultiert.

Während der Widerstand R7 als Festwiderstand dargestellt ist, kann er auch einstellbar gemacht werden, um den Übergang auf verschiedene Werte einzustellen. Außerdem kann die Schottkydiode SBD6, die zur Stromanzapfung dient, durch ein Widerstandselement ersetzt werden.

Die Schaltung nach Fig. 2 kann auch als Schaltung mit offenem Kollektorausgang betrieben werden. In diesem Falle sind die Transistoren T2 und T3 eliminiert und der Kollektor des Ausgangstransistors T4 ist »offen«. Die Wirkungsweise dieser Schaltung ist die gleiche wie die der beschriebenen.

**Patentansprüche**

1. Gegentakt-Treiberschaltung mit verringerter Störspannungserzeugung durch den den niedrigen Ausgangspegel herbeiführenden Ausgangstransistor (T4), gekennzeichnet durch einen bei hohem Ausgangspegel leitenden zusätzlichen Transistor (T5), der bei beginnendem Leitendwerden des den niedrigen Ausgangspegel herbeiführenden Ausgangstransistors (T4) einen mit abnehmendem Ausgangspegel immer geringer werdenden Teil des für diesen Transistor bestimmten Steuerstromes ableitet, wodurch auch der gesteuerte Strom dieses Ausgangstransistors langsamer ansteigt.

2. Gegentakt-Treiberschaltung nach Anspruch 1, dadurch gekennzeichnet, daß das Ableiten des mit abnehmendem Ausgangspegel immer geringer werdenden Teiles des Steuerstromes, der für den den niedrigen Ausgangspegel herbeiführenden Ausgangstransistor bestimmt ist, über eine Reihenschaltung aus einer Schottky-Diode (SBD6) und dem zusätzlichen Transistor (T5) erfolgt.

3. Gegentakt-Treiberschaltung nach den Ansprüchen 1 oder 2, dadurch gekennzeichnet, daß die Basis des zusätzlichen Transistors (T5) über einen Widerstand (R7), der in Verbindung mit der Größe des Steuerstromes für den den niedrigen Ausgangspegel herbeiführenden Ausgangstransistor den Abschaltpunkt des zusätzlichen Transistors bei abfallendem Ausgangspegel bestimmt, an den Ausgang (Ā) der Treiberschaltung angeschlossen ist.

**Claims**

1. Push-pull driver circuit with reduced noise voltage generation by the output transistor (T4) causing the low output level, characterized by an additional transistor (T5) that is conductive at the high output level and that, when the output transistor (T4) causing the low output level is becoming conductive diverts a part of the control current for this transistor which decreases with the decreasing output level, so that the controlled current of this output transistor increases more slowly.

2. Push-pull driver circuit as claimed in claim 1, characterized in that the diverting of the decreasing part of the control current determined for the output transistor which causes the low output level is effected via a series arrangement consisting of a Schottkydiode (SBD6) and the additional transistor (T5).

3. Push-pull driver circuit as claimed in any one of claims 1 or 2, characterized in that the base of the additional transistor (T5) is connected to the output (Ā) of the driver circuit via a resistor (R7) which in connection with the height of the control current for the output transistor causing the low output level determines the switch-off point of the additional transistor upon decreasing output level.

**Revendications**

1. Circuit d'attaque complémentaire à production réduite de tensions parasites par le transistor de sortie (T4) fournissant le niveau de sortie bas, caractérisé par un transistor supplémentaire (T5), conducteur pour un niveau de sortie haut, qui, lorsque le transistor de sortie (T4) fournissant le niveau de sortie bas commence à devenir conducteur, dérive une partie, qui diminue de plus en plus lorsque le niveau de sortie diminue, du courant de commande destiné à ce transistor, ce qui a pour effet que le courant commandé de ce transistor de sortie augmente plus lentement.

2. Circuit d'attaque complémentaire selon la revendication 1, caractérisé en ce que la dérivation de la partie, qui devient de plus en plus faible lorsque le niveau de sortie diminue, du courant de commande qui est destiné au transistor de sortie fournissant le niveau de sortie bas est réalisée par l'intermédiaire d'un circuit série formé d'une diode Schottky (SBD6) et du transistor supplémentaire (T5).

3. Circuit d'attaque complémentaire selon les revendications 1 ou 2, caractérisé en ce que la base du transistor supplémentaire (T5) est rac-

cordée à la sortie (Ā) du circuit d'attaque par l'intermédiaire d'une résistance (R7) qui, en liaison avec l'intensité du courant de commande pour le transistor de sortie fournissant le niveau de sortie bas, détermine le point de blocage du transistor supplémentaire lorsque le niveau de sortie diminue.

# FIG.1

# FIG.2